# EUROPÄISCHE PATENTSCHRIFT

(11) **EP 0 656 647 B1**
(45) Veröffentlichungstag und Bekanntmachung des Hinweises auf die Patenterteilung: **20.01.1999**
(21) Anmeldenummer: 94117699.2
(22) Anmeldetag: 09.11.1994
(51) Int. Cl.: H01L 21/336, H01L 29/78

(54) **Verfahren zur Herstellung einer integrierten Schaltungsanordnung mit mindestens einem MOS-Transistor**
Method of fabricating an integrated circuit device comprising at least a MOS transistor
Procédé de fabrication d'un dispositif de circuit intégré comportant au moins un transistor MOS

(30) Priorität: 01.12.1993 DE 4340967
(43) Veröffentlichungstag der Anmeldung: 07.06.1995
(73) Patentinhaber: SIEMENS AKTIENGESELLSCHAFT, 80333 München (DE)
(72) Erfinder: Risch, Lothar, Dr., D-85579 Neubiberg (DE); Hofmann, Karl, Dr., D-30974 Wennigsen (DE); Vogelsang, Thomas, Dipl.-Phys., Essex Junction, VT 05452 (US); Hofmann, Franz, Dr., D-80995 München (DE)

(56) Entgegenhaltungen:
- US-A- 4 740 826
- US-A- 4 951 102
- US-A- 5 072 276
- PATENT ABSTRACTS OF JAPAN vol. 14, no. 244 (E-0932) 24. Mai 1990 & JP-A-02 066 969 (NEC CORP) 7. März 1990
- EXTENDED ABSTRACTS OF THE 1993 INT. CONF. ON SOLID STATE DEVICES AND MATERIALS, 29. August 1993, CIBA, JAPAN Seiten 422 - 424 H. GOSSNER ET AL. 'Vertical Si-MOSFETs with Channel Lengths Down to 45 nm.'

## Beschreibung

In integrierten Schaltungen werden CMOS-Transistoren und logische Gatter derzeit meist in einer planaren Siliziumtechnologie realisiert, bei der Source, Kanalbereich und Drain lateral angeordnet sind. Die erreichbaren Gatelangen sind dabei abhängig vom Auflösungsvermögen der verwendeten optischen Lithographie und von Toleranzen bei der Strukturierung und Justierung. In der 16 M-Generation werden typische Gatelängen von 0,6 µm, in der 64 M-Generation von 0,35 µm erreicht.

Im Hinblick auf die elektrischen Eigenschaften von MOS-Transistoren sowie auf eine erhöhte Packungsdichte, die insbesondere bei komplexen logischen Schaltungen wie logischen Gattern bedeutsam wird, da dort mehrere n- und p-Kanaltransistoren zusätzlich gegeneinander isoliert und miteinander verdrahtet werden müssen, wird eine weitere Verkleinerung der lateralen Kanal langen angestrebt. Dazu sind Verbesserungen der optischen Lithographie sowie der Lack- und Ätztechnik erforderlich. Wegen des begrenzten Auflösungsvermögens der optischen Lithographie und zunehmender Probleme mit Toleranzen bei der Strukturierung und Justierung erscheint es jedoch fraglich, ob sich auf diese Weise reproduzierbar Transistoren mit Kanallängen unter 100 nm herstellen lassen. Darüber hinaus führt die Verkleinerung der lateralen Kanal lange zu Veränderungen der elektrischen Eigenschaften des MOS-Transistors, die durch eine Implantation von Dotierstoffen im Kanalgebiet sowie aufwendige Source/Drain-Konstruktionen ausgeglichen werden müssen.

Geringere Strukturgrößen in planarer Technologie können erzielt werden, wenn die optische Lithographie durch Elektronenstrahllithographie ersetzt wird. Im Labormaßstab ist es bisher gelungen, mit einem Elektronenstrahlschreiber einzelne funktionsfähige MOS-Transistoren mit Kanal längen bis zu 50 nm herzustellen. Da die Elektronenstrahllithographie jedoch langsam ist, erscheint sie für einen Einsatz in einer Halbleiterfertigung aus wirtschaftlichen Gründen als ungeeignet.

In den achtziger Jahren ist vorgeschlagen worden (siehe zum Beispiel F. E. Holmes et al, Solid State Electronics, 17 (1974), S. 791 ff) in der sogenannten V-MOS-Technologie vertikale Transistoren herzustellen. Dabei werden Source, Kanalbereich und Drain als vertikale Schichtenfolgen in einem Substrat realisiert. Gatedielektrikum und Gateelektrode werden an der Oberfläche eines Grabens, der ein V-förmiges Profil aufweist, realisiert. Dadurch konnten Transistoren mit kürzeren Kanallängen hergestellt werden, als es die damalige Lithographie erlaubte. Da in diesen Transistoren jedoch nur die Kanal länge klein war, traten bei dieser Technik große parasitäre Kapazitäten auf. Daher hat dieser Vorschlag in der Logikentwicklung gegenüber planaren Herstellungsverfahren keine Bedeutung erlangt.

In der DRAM-Speicherentwicklung wurde von Texas Instruments (siehe zum Beispiel W. F. Richardson et al, IEDM Dig. Tech. Paper (1985), S. 714 bis 717) vorgeschlagen, in der sogenannten "Trench Tranistor Zelle" Transistor und Kondensator vertikal zu integrieren. Der dort vorgeschlagene Transistor weist eine Kanallänge im Bereich von etwa 1 µm auf. In der Speicherentwicklung hat sich in der Folge nur die Anordnung des Kondensators im Trench durchgesetzt.

In US-A-5 022 276 ist ein PMOS-Transistor beschrieben, der an einer Flanke einer Schichtenfolge angeordnet ist. Die Schichtenfolge umfaßt ein Kanalgebiet und ein Draingebiet. Zur Erzeugung der Schichtenfolge wird zunächst auf einer Oberfläche eines Halbleitersubstrats eine isolierende Schicht aufgebracht, in der eine Öffnung erzeugt wird. In der Öffnung wird durch Epitaxie eine Struktur aufgewachsen wird. Anschließend wird eine Polysiliziumschicht erzeugt und durch Implantation dotiert. Durch Ausdiffusion von Dotierstoff der Polysiliziumschicht in die Struktur entsteht aus der Struktur das die Schichtenfolge.

In H.Gossner et al, extended abstract of the 1993 Int.Conf. on Solid State Devices an Materials, Makuhari, 1993 S. 422 bis 424 wird ein vertikaler Transistor und ein Verfahren zu dessen Herstellung beschrieben. Der vertikale Transistor ist an Flanken einer Halbleiterstruktur angeordnet, die von einer Gateelektrode umgeben ist. Die Halbleiterstruktur umfaßt Schichten entsprechend Source, Kanal und Drain. Die Halbleiterstruktur wird durch maskiertes Ätzen einer ganzflächigen Schichtenfolge erzeugt.

In US-A 4 740 826 wird ein Inverter und ein Verfahren zu dessen Herstellung beschrieben. Die zwei komplementären Transistoren des Inverters sind übereinander angeordnet und vertikal ausgebildet. Zu ihrer Erzeugung wird ganzflächig eine Schichtenfolge erzeugt, mit Schichten entsprechend der Source, Kanal und Drain der Transistoren. Zur Erzeugung einer Gateelektrode wird in die Schichtenfolge ein erster Graben geätzt, der mit einem Gatedielektrikum versehen und mit leitendem Material gefüllt wird. Zur Erzeugung eines Kontaktes von mittleren Schichten der Schichtenfolge wird ein zweiter Graben erzeugt, in dem eine isolierende Schicht, eine leitende Schicht und eine isolierende Schicht derart übereinander angeordnet werden, daß die leitende Schicht an die zu kontaktierenden mittleren Schichten angrenzt.

In der Einleitung zur Dissertation von W. Kiunke, 1992, Universität der Bundeswehr Fakultät für Elektrotechnik, Institut für Physik, Neubiberg, Seite 2 bis 3, wird ein Überblick über Einsatzmöglichkeiten der Molekularstrahlepitaxie gegeben. Bei der Molekularstrahlepitaxie können kontrolliert homogene Schichten mit einer minimalen Dicke um eine Atomlage hergestellt werden. Durch Zugabe von Dotierstoff enthaltendem Gas ist eine Dotierung im Bereich von 10¹⁴ cm⁻³ bis 10²⁰ cm⁻³ in situ während der Epitaxie möglich. Als Anwendungsbeispiel wird über einen Vorschlag für einen vertikalen CMOS-Inverter berichtet. Der vorgeschlagene Inverter ist als Mesastruktur auf einem Substrat realisiert. Die Mesastruktur umfaßt eine npnpnp-Schichtenfolge mit senkrechten Flanken. An einer Seite sind sämtliche senkrechten Flanken der Schichten mit einem Gatedielektrikum und einer Gateelektrode versehen. Die Gateelektrode ist gegenüber dem Substrat nur durch das Gatedielektrikum isoliert, so daß dieser Aufbau große parasitäre Kapazitäten aufweist.

Der Erfindung liegt das Problem zugrunde, ein Herstellungsverfahren für MOS-Transistoren mit definierter Kanal lange im Bereich bis unter 50 nm anzugeben. Das Verfahren soll insbesondere geeignet sein zur Herstellung von kompakten, schnellen logischen Gattern.

Dieses Problem wird erfindungsgemäß gelost durch ein Verfahren nach Anspruch 1. Weitere Ausgestaltungen der Erfindung gehen aus den übrigen Ansprüchen hervor.

In dem erfindungsgemäßen Verfahren wird an einer Hauptfläche eines Substrats ein Sourceanschlußgebiet erzeugt. Als Substrat wird insbesondere ein Siliziumwafer verwendet. Das Sourceanschlußgebiet kann an der Hauptfläche des Siliziumwafers sowohl als durchgehende entsprechend dotierte Schicht als auch als dotierte Wanne gebildet werden. Alternativ kann als Substrat auch ein SOI-Substrat verwendet werden. In diesem, das eine Siliziumscheibe, eine darauf angeordnete isolierende Schicht und eine darauf angeordnete einkristalline Siliziumschicht umfaßt, wird das Sourceanschlußgebiet in der einkristallinen Siliziumschicht realisiert. Zur Erzielung höchster Packungsdichte wird es von einem isolierenden Graben umgeben.

Nach Erzeugung des Sourceanschlußgebietes wird auf die Hauptfläche ganzflächig eine isolierende Schicht aufgebracht, in der eine erste Öffnung erzeugt wird. Innerhalb der ersten Öffnung liegt die Oberfläche für das spätere Sourcegebiet frei. Durch epitaktisches Aufwachsen von dotiertem Halbleitermaterial wird in der ersten Öffnung eine vertikale Schichtenfolge erzeugt, die mindestens einen Kanalbereich und ein Draingebiet und vorzugsweise zusätzlich ein Sourcegebiet für den MOS-Transistor umfaßt. Umfaßt die Schichtenfolge nur den Kanalbereich und das Draingebiet, so wirkt das Sourceanschlußgebiet auch als Sourcegebiet.

Zur Herstellung der vertikalen Schichtenfolge sind alle Epitaxieverfahren geeignet. Vorzugsweise wird die Schichtenfolge durch Molekularstrahlepitaxie , mit der besonders dünne Schichten hergestellt werden können, oder durch eine selektive Epitaxie, insbesondere in einem RTP-CVD-Verfahren mit SiH₂Cl₂-Gas, wobei jeweils zur insitu-Dotierung ein entsprechendes Dotiergas zugegeben wird, hergestellt. Wird zum Aufwachsen der Schichtenfolge ein nicht selektives Verfahren verwendet, so wächst Halbleitermaterial sowohl auf der Oberfläche des Sourceanschlußgebietes als auch auf der Oberfläche der isolierenden Schicht auf. Auf der Oberfläche des Sourceanschlußgebietes wächst das Halbleitermaterial einkristallin, auf der Oberfläche der isolierenden Schicht jedoch polykristallin auf. Das polykristalline Halbleitermaterial kann anschließend selektiv zum einkristallinen Schichtaufbau entfernt werden. Die Anwendung eines selektiven Epitaxieverfahrens hat den Vorteil, daß dieser Ätzschritt entfällt.

In der Schichtenfolge wird anschließend eine zweite Öffnung erzeugt, die mindestens so tief ist, wie es der Summe der Dicken von Draingebiet und Kanalbereich und gegebenenfalls zusätzlich des Sourcegebietes entspricht. Auf der Oberfläche der zweiten Öffnung wird ein Gatedielektrikum und darauf eine Gateelektrode aufgewachsen. Im Betrieb des auf diese Weise hergestellten MOS-Transistors bildet sich entlang der Oberfläche der zweiten Öffnung im Kanalbereich ein leitender Kanal aus. Da die zweite Öffnung im Innern des Schichtaufbaus, wo das Kristallgefüge im wesentlichen defektfrei ist, angeordnet wird, lassen sich im erfindungsgemäßen Verfahren MOS-Transistoren mit guten elektrischen Eigenschaften herstellen.

Das erfindungsgemäße Herstellverfahren ist geeignet zum Aufbau eines Inverters, der zwei zueinander komplementäre Transistoren umfaßt. Dazu werden Schichtenfolgen mit entsprechenden Dotierungen in der ersten Öffnung aufgewachsen.

Schichten, die in der Schaltung Source/Drain-Gebiete bilden, werden hochdotiert und in einer Dicke von 50 bis 200 nm abgeschieden. Schichten, die in der Schaltung Kanalbereiche bilden, werden schwächer dotiert mit Dotierstoffkonzentrationen im Bereich 10¹⁷ bis 10¹⁸ cm⁻³ und werden in einer Dicke von 10 bis 200 nm, vorzugsweise 50 bis 100 nm abgeschieden. Die Dicke dieser Schichten entspricht der Kanal länge des entsprechenden MOS-Transistors.

Es ist besonders vorteilhaft, die Schichtdicken auf die Tiefe der ersten Öffnung so abzustimmen, daß die Schichtenfolge mit der Oberfläche der isolierenden Schicht im wesentlichen planar abschließt. Dadurch wird eine Schaltunganordnung mit planarem Aufbau erzielt.

Es ist besonders vorteilhaft, diejenigen Schichten, die Kanalbereiche bilden, mit einer Dotierung von kleiner oder gleich 10¹⁸ cm⁻³ zu versehen, während diejenigen Schichten, die Source/Drain-Gebiete bilden, mit einer Dotierung von größer oder gleich 10¹⁹ cm3 versehen werden, und das Gatedielektrikum durch thermische Oxidation bei 700 bis 800°C zu bilden. Dabei bildet sich das Gatedielektrikum auf den hoher dotierten Gebieten mit etwa fünffacher Dicke im Vergleich zu den schwächer dotierten Schichten, die als Kanalbereich eingesetzt werden. Die größere Dicke des Gatedielektrikums an der Oberfläche der Source/Drain-Gebiete bewirkt eine Reduktion der Überlappkapazitäten.

Im folgenden wird die Erfindung anhand der Ausführungsbeispiele und der Figuren näher erläutert.
- Figur 1: zeigt ein Substrat mit einem Sourceanschlußgebiet und einer isolierenden Schicht, die eine Öffnung aufweist.
- Figur 2: zeigt das Substrat nach Erzeugung eines Schichtaufbaus in der Öffnung der isolierenden Schicht.
- Figur 3: zeigt einen vertikalen MOS-Transistor, der in den Schichtaufbau realisiert ist.
- Figur 4: zeigt einen Aufblick auf den vertikalen MOS-Transistor.
- Figur 5: zeigt einen vertikalen Inverter, der in einem Schichtaufbau realisiert ist.
- Figur 6: zeigt ein Prinzipschaltbild des Inverters.

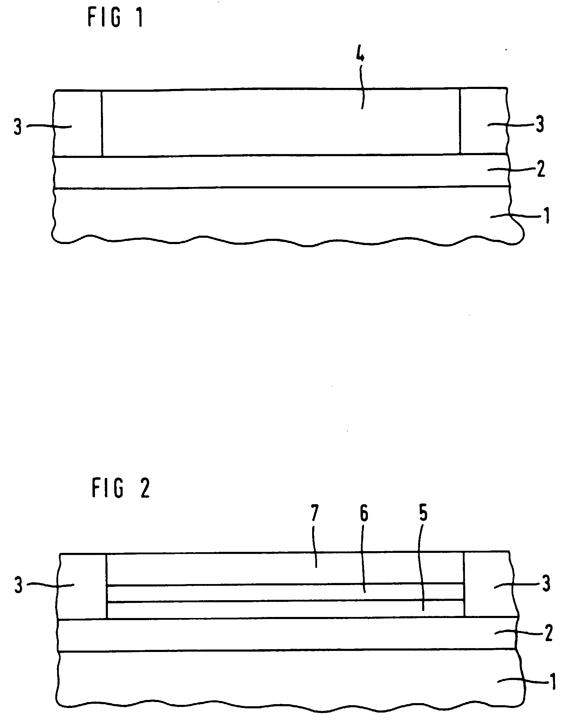

Zur Herstellung eines MOS-Transistors wird an einer Hauptfläche eines Substrats 1 aus zum Beispiel p-dotiertem, einkristallinem Silizium, ein Sourceanschlußgebiet 2 erzeugt. Das Sourceanschlußgebiet 2 wird n⁺-dotiert. Das Sourceanschlußgebiet 2 wird mit P, Sb oder As dotiert und weist eine Dotierstoffkonzentration von etwa 10²⁰ cm⁻³ auf. Das Sourceanschlußgebiet 2 kann als durchgehende Schicht oder als Wanne realisiert sein (siehe Figur 1).

Es wird eine isolierende Schicht 3 aufgebracht, die die Oberfläche des Sourceanschlußgebietes 2 bedeckt. Die isolierende Schicht 3 wird zum Beispiel aus SiO₂ erzeugt. Dies erfolgt durch Abscheidung in einer Dicke von etwa 200 nm oder durch Oxidation in entsprechender Dicke.

In der isolierenden Schicht 3 wird mit einem Lithographieschritt eine erste Öffnung 4 erzeugt. Die erste Öffnung 4 wird zum Beispiel durch anisotropes Ätzen gebildet. Im Bereich der ersten Öffnung 4 liegt die Oberfläche des Sourceanschlußgebietes 2 frei.

Innerhalb der ersten Öffnung 4 wird vorzugsweise durch selektive Epitaxie ein Schichtaufbau aus Silizium erzeugt, der die erste Öffnung 4 im wesentlichen ausfüllt und mit der isolierenden Schicht 3 eine im wesentlichen ebene Oberfläche bildet. Als selektive Epitaxie ist insbesondere eine Molekularstrahlepitaxie im Temperaturbereich zwischen 400 und 700°c und im Druckbereich zwischen 0,1 mbar und 10 mbar oder ein RTP-CVD-Verfahren mit SiH₂Cl₂-Gas als Prozeßgas geeignet. Die Dotierung der die Schichtenfolge bildenden Schichten erfolgt insitu bei der Epitaxie durch Zugabe eines Dotierstoff enthaltenden Gases zum Prozeßgas. Zur Erzeugung von n-dotierten Schichten wird insbesondere AsH₃, SbH₃ oder PH₃ zugegeben. Zur Herstellung von p-dotierten Schichten wird insbesondere B₂H₆ zugegeben.

In der ersten Öffnung 4 wird auf der Oberfläche des Sourceanschlußgebietes 2 eine erste Schicht 5 aufgewachsen. Die erste Schicht 5 wird durch Zugabe von Sb oder As mit einer Dotierstoffkonzentration von etwa 10²⁰ cm⁻³ n⁺-dotiert. Die erste Schicht 5 wird in einer Schichtdicke von etwa 50 nm aufgewachsen (siehe Figur 2).

Auf die erste Schicht 5 wird eine zweite Schicht 6 aufgewachsen, die durch Zugabe von B₂H₆ bei der Epitaxie insitu-p-dotiert wird. Die zweite Schicht 5 weist eine Dotierstoffkonzentration von etwa 10¹⁸cm⁻³ und eine Dicke von etwa 50 nm auf. Die zweite Schicht 6 bildet ein Kanalgebiet.

Auf die zweite Schicht 6 wird eine dritte Schicht 7 aufgewachsen,die ein Draingebiet bildet. Die dritte Schicht 7 wird n⁺-dotiert mit einer Dotierstoffkonzentration von etwa 10²⁰ cm⁻³. Dazu wird bei der selektiven Epitaxie dem Prozeßgas AsH₃ zugegeben. Die dritte Schicht 7 wird in einer Schichtdicke von etwa 100 nm aufgewachsen. Die erste Schicht 5, die zweite Schicht 6 und die dritte Schicht 7 bilden einen Schichtaufbau, der die erste Öffnung 4 vollständig ausfüllt (siehe Figur 2).

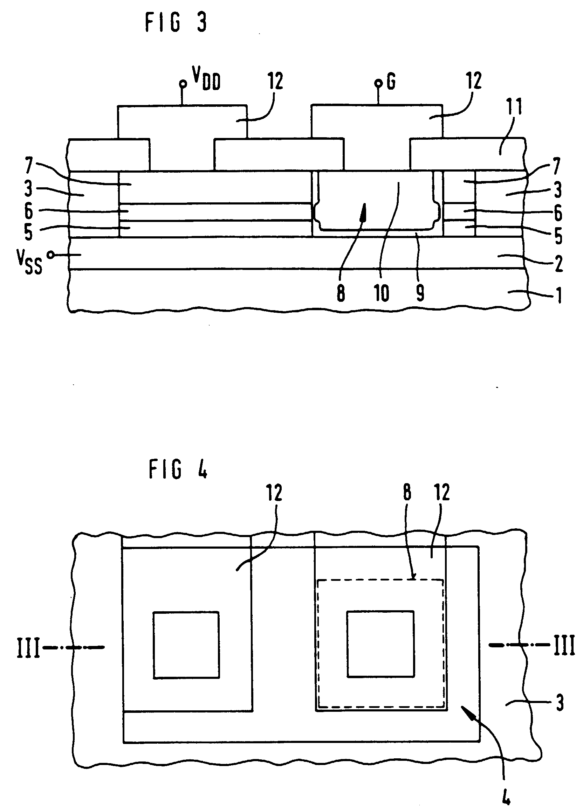

In dem aus erster Schicht 5, zweiter Schicht 6 und dritter Schicht 7 gebildeten Schichtaufbau wird unter Verwendung eines Lithographieschrittes eine zweite Öffnung 8 geätzt. Die zweite Öffnung 8 muß mindestens bis in die erste Schicht 5 hineinreichen. Vorzugsweise wird die zweite Öffnung 8 bis auf die Oberfläche des Sourceanschlußgebietes 2 geätzt (siehe Figur 3).

Anschließend wird durch Oxidation bei einer Temperatur im Bereich zwischen 700 und 800°C ein Gatedielektrikum 9 erzeugt. Die Oxidationszeit wird dabei so eingestellt, daß sich an der Oberfläche der zweiten Schicht 6 eine Dicke des Gatedielektrikums 9 von etwa 5 nm einstellt. In dieser Zeit bildet sich an der Oberfläche der hochdotierten ersten Schicht 5, dritten Schicht 7 sowie des Sourceanschlußgebietes eine um den Faktor 5 größere Dicke. Dieses bewirkt eine Reduktion der Überlappkapazität.

Anschließend wird der verbleibende Freiraum innerhalb der zweiten Öffnung 8 mit n⁺-dotiertem Polysilizium aufgefüllt. Das n⁺-dotierte Polysilizium bildet eine Gateelektrode 10.

Die dritte Schicht 7, die n⁺-dotiert ist, bildet ein Draingebiet, die zweite Schicht 6, die p-dotiert ist, bildet ein Kanalgebiet, die erste Schicht 5, die ein Sourcegebiet bildet, und das Sourceanschlußgebiet 2, die jeweils n⁺-dotiert sind, bilden gemeinsam das wirksame Sourcegebiet des MOS-Transistors. Die erste Schicht 5 wird auf das Sourceanschlußgebiet 2 aufgewachsen, um eine lineare, vertikale Anordnung von Source, Kanal und Drain sicherzustellen. Die Weite des MOS-Transistors ist bestimmt durch den Umfang der zweiten Öffnung 8. Die Kanallänge des MOS-Transistors ist bestimmt durch die Dicke der zweiten Schicht 6. Mit Hilfe von Molekularstrahlepitaxie oder eines RTP-CVD-Verfahrens, das im Temperaturbereich 400°C und 700°C und Druckbereich zwischen 0,1 mbar und 10 mbar eingesetzt wird, können Schichten mit minimalen Dicken bis zu 5 nm hergestellt werden. Diese Schichtdicke ist die Untergrenze der Kanal länge, die mit dem erfindungsgemäßen Herstellverfahren hergestellt werden kann.

Auf die isolierende Schicht 3, die dritte Schicht 7, und die die Gateelektrode 10 bildende Polysiliziumfüllung wird ganzflächig eine Isolationsschicht 11 aufgebracht. In der Isolationsschicht 11 werden Kontaktlöcher zur Gateelektrode 10 sowie zur dritten Schicht 7, die als Draingebiet wirkt, geöffnet und mit Metallisierungen 12 versehen. Seitlich der ersten Öffnung 4 wird das Sourceanschlußgebiet 2 zum Beispiel durch ein tiefreichendes mit einer Metallisierung gefülltes Kontakt loch, das die Isolationsschicht 11 und die isolierende Schicht 3 durchquert, kontaktiert. Im Betrieb des MOS-Transistors wird das Sourceanschlußgebiet 2 mit der Versorgungsspannung V_{SS}, die dritte Schicht 7 mit der Versorgungsspannung V_{DD} und die Gateelektrode 10 mit der Gatespannung G verbunden.

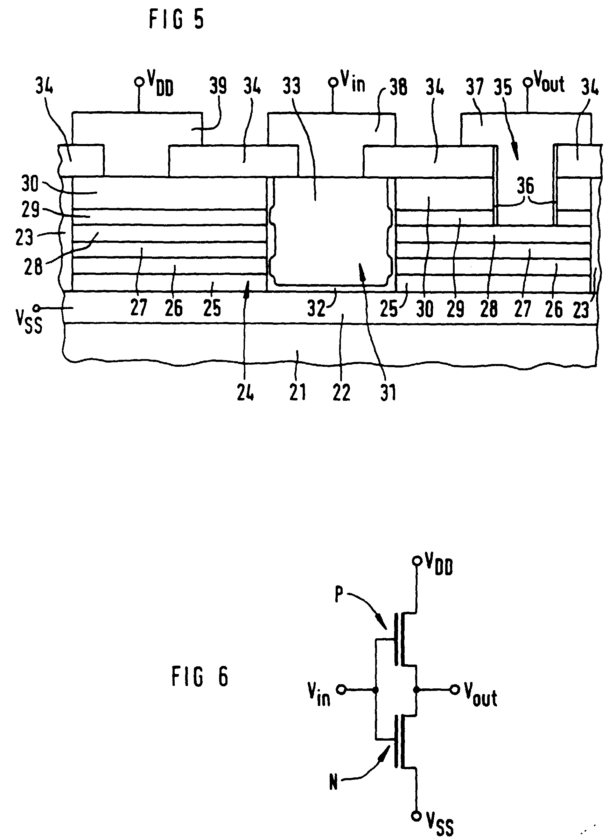

Figur 4 zeigt eine Aufsicht auf den anhand von Figur 3 erläuterten MOS-Transistor. Der in Figur 3 dargestellte Schnitt ist in Figur 4 mit III-III bezeichnet. Die vom Schichtaufbau ausgefüllte erste Öffnung 4 weist im Beispiel einer Abmessung von 1,2 µm x 2,2 µm auf. Die die Weite des Transistors bestimmende zweite Öffnung hat eine Abmessung von 0,8 µm x 0,8 µm. Die Kontaktlöcher auf die dritte Schicht 7, die als Draingebiet wirkt sowie die Gateelektrode 10 weisen einen Querschnitt von etwa 0,4 µm x 0,4 µm auf. Der Querschnitt der zweiten Öffnung 8 ist als gestrichelte Linie in Figur 4 eingetragen.
Zur Herstellung eines Inverters wird bei einer Hauptfläche eines Substrats 21, das zum Beispiel aus p-dotiertem einkristallinem Silizium besteht, ein Sourceanschlußgebiet 22 gebildet (siehe Figur 5). Das Sourceanschlußgebiet 22 ist zum Beispiel n⁺-dotiert mit einer Dotierstoffkonzentration von 10²⁰ cm⁻³. Das Sourceanschlußgebiet 22 kann als durchgehende Schicht oder als Wanne ausgebildet sein. Das Sourceanschlußgebiet 22 wird vorzugsweise durch Diffusion hergestellt.

Auf das Sourceanschlußgebiet 22 wird ganzflächig eine isolierende Schicht 23 aufgebracht, die zum Beispiel aus SiO₂ besteht und die eine Dicke von zum Beispiel 350 nm aufweist. In der isolierenden Schicht 23 wird eine erste Öffnung 24 geöffnet. Die erste Öffnung 24 wird mit Hilfe eines Lithographieschrittes zum Beispiel durch anisotropes Ätzen erzeugt. Innerhalb der ersten Öffnung 24 wird die Oberfläche des Sourceanschlußgebietes 22 freigelegt.

Innerhalb der ersten Öffnung 24 wird durch selektive Epitaxie ein Schichtaufbau aus Silizium aufgewachsen, der die erste Öffnung 24 im wesentlichen auffüllt. Die selektive Epitaxie, bei der Silizium im wesentlichen nur auf der Oberfläche von Silizium aufwächst, während auf der Oberfläche der isolierenden Schicht 23 kein Silizium aufwächst, wird zum Beispiel als RTP-CVD-Epitaxie mit SiH₂Cl₂-Gas im Temperaturbereich von 400 bis 700°C und im Druckbereich von 0,1 bis 10 mbar durchgeführt. Durch Zugabe eines entsprechenden Dotiergases werden die Schichten insitu dotiert abgeschieden.

In der ersten Öffnung 24 wird auf der Oberfläche des Sourceanschlußgebietes 22 eine erste Schicht 25, die ein Sourcegebiet bildet, aufgewachsen, die n⁺-dotiert mit einer Dotierstoffkonzentration von etwa 10²⁰ cm⁻³ ist. Die erste Schicht 25 wird in einer Dicke von etwa 50 bis 100 nm aufgewachsen.

Auf die erste Schicht 25 wird eine zweite Schicht 26 aufgewachsen, die p-dotiert ist und die eine Dicke von etwa 50 nm aufweist. Die zweite Schicht 26 bildet im Inverter ein Kanalgebiet. Die zweite Schicht 26 weist eine Dotierstoffkonzentration von etwa 10¹⁸ cm⁻³ auf.

Auf die zweite Schicht 26 wird eine dritte Schicht 27 aufgewachsen, die n⁺-dotiert ist mit einer Dotierstoffkonzentration von etwa 10²⁰ cm⁻³ und eine Dicke von etwa 50 bis 100 nm aufweist.

Auf die dritte Schicht 27 wird eine vierte Schicht 28 aufgewachsen, die p⁺-dotiert wird mit einer Dotierstoffkonzentration von etwa 10²⁰ cm⁻³ und die in einer Dicke von etwa 50 bis 100 nm aufgewachsen wird.

Auf die vierte Schicht 28 wird eine fünfte Schicht 29 aufgewachsen, die n-dotiert wird mit einer Dotierstoffkonzentration von etwa 10¹⁸ cm⁻³ und die in einer Dicke von etwa 50 nm aufgewachsen wird. Die fünfte Schicht 29 bildet im fertigen Inverter ein Kanalgebiet.

Auf die fünfte Schicht 29 wird eine sechste Schicht 30 aufgewachsen, die p⁺-dotiert wird mit einer Dotierstoffkonzentration von etwa 10²⁰ cm⁻³ und die in einer Dicke von etwa 50 bis 100 nm abgeschieden wird. Die sechste Schicht 30 schließt in der Höhe im wesentlichen mit der Oberfläche der isolierenden Schicht 23 ab.

In dem Schichtaufbau, der aus der ersten Schicht 25, der zweiten Schicht 26, der dritten Schicht 27, der vierten Schicht 28, der fünften Schicht 29 und der sechsten Schicht 30 gebildet wird, wird unter Verwendung eines Lithographieschrittes eine zweite Öffnung 31 erzeugt, die mindestens bis in die erste Schicht 25 hineinreicht. Vorzugsweise reicht die zweite Öffnung 31 bis auf die Oberfläche des Sourceanschlußgebietes 22.

Nachfolgend wird bei vorzugsweise 700 bis 800°C eine Oxidation durchgeführt, bei der entlang der Oberfläche der zweiten Öffnung 31 ein Gatedielektrikum 32 gebildet wird. Die Oxidationszeit wird so eingestellt, daß an der Oberfläche der zweiten Schicht 26 sowie der fünften Schicht 29, die im Inverter jeweils Kanalgebiete bilden, eine Schichtdicke von etwa 5 nm entsteht. Wegen des Unterschiedes in der Dotierstoffkonzentration entsteht dabei an der Oberfläche der hoher dotierten ersten Schicht 25, dritten Schicht 27, vierten Schicht 28, sechsten Schicht 30 und des Sourceanschlußgebietes 22 eine etwa fünffach vergrößerte Schichtdicke. Gleichzeitig entsteht an der Oberfläche der sechsten Schicht 30 außerhalb der zweiten Öffnung 31 eine SiO₂-Schicht, die der Übersichtlichkeit halber in Figur 5 nicht dargestellt ist.

Der verbliebene Freiraum innerhalb der zweiten Öffnung 31 wird zur Bildung einer Gateelektrode 33 mit n⁺-dotiertem Polysilizium aufgefüllt.

Auf die Oberfläche der isolierenden Schicht 23, der sechsten Schicht 30 und der Gateelektrode 33 wird eine Isolationsschicht 34 aus zum Beispiel SiO₂ aufgebracht. Es wird durch die Isolationsschicht 34, die sechste Schicht 30 und die fünfte Schicht 29 eine dritte Öffnung erzeugt, die bis auf die Oberfläche der vierten Schicht 28 reicht. Die Seitenwände der dritten Öffnung 35 werden mit isolierenden Spacern 36 versehen. Die isolierenden Spacer 36 werden zum Beispiel durch konforme Abscheidung einer dünnen SiO₂-Schicht und anschließendes anisotropes Ätzen der SiO₂-Schicht hergestellt. Die dritte Öffnung 35 wird mit einer Metallisierung aufgefüllt, wobei ein Ausgangskontakt 37 gebildet wird. Zur Bildung eines Eingangskontaktes 36 wird in die Isolationsschicht 34 ein Kontakt loch auf die Gateelektrode 33 geöffnet und mit einer Metallisierung versehen. Zur Herstellung eines Kontaktes 39 für eine erste Versorgungsspannung V_{DD} wird in der Isolationsschicht 34 ein weiteres Kontaktloch geöffnet, das auf die Oberfläche der sechsten Schicht 30 reicht und das mit einer Metallisierung versehen wird. Das Sourceanschlußgebiet 22 wird über ein mit einer Metallisierung gefüllten Kontakt loch in der Isolationsschicht 34 und der isolierenden Schicht 23 außerhalb des in Figur 5 gezeigten Ausschnittes kontaktiert und im Betrieb mit einer zweiten Versorgungsspannung V_{SS} verbunden.

Das Sourceanschlußgebiet 22, die erste Schicht 25, die zweite Schicht 26 sowie die dritte Schicht 27 bilden mit dem Gatedielektrikum 32 und der Gateelektrode 33 einen n-Kanal-MOS-Transistor N des Inverters (siehe Figur 6). In dem n-Kanal-Transistor N wirkt die zweite Schicht 26 als Kanalgebiet, während Sourceanschlußgebiet 22 und erste Schicht 25 als Source wirken und die dritte Schicht 27 als Drain. Die vierte Schicht 28, die fünfte Schicht 29, die sechste Schicht 30, das Gatedielektrikum 32 und die Gateelektrode 33 bilden einen p-Kanal-MOS-Transistor P des Inverters (siehe Figur 6). Dabei wirkt die fünfte Schicht 29 als Kanalgebiet, während die vierte Schicht 28 als Sourceanschlußgebiet und die sechste Schicht 30 als Draingebiet wirken. Die dritte Schicht 27 ist mit der vierten Schicht 28 über einen Tunneleffekt beziehungsweise den Kontakt 35 verbunden, der bei Dotierstoffkonzentrationen von 10²⁰ cm⁻³ zwischen einem n⁺-dotierten Gebiet und einem p⁺-dotierten Gebiet auftreten. Der Ausgangskontakt 37 kontaktiert damit über die vierte Schicht 28 auch die dritte Schicht 27. In dem Inverter wird ein Eingangssignal Vᵢₙ über den Eingangskontakt 38 angelegt und ein Ausgangssignal Vₒᵤₜ über den Ausgangskontakt 37 abgenommen.

Durch Anordnen mehrerer Inverter in benachbarten ersten Öffnungen nebeneinander und Verbinden jeweils des Ausgangskontaktes des einen Inverters mit dem Eingangs kontakt des nächsten Inverters kann unter Verwendung des erfindungsgemäßen Herstellverfahrens auf einfache Weise ein Ringoszillator aufgebaut werden.

## Patentansprüche

1. Verfahren zur Herstellung einer integrierten Schaltungsanordnung mit mindestens einem MOS-Transistor,
- bei dem an einer Hauptfläche eines Substrats (1) ein Sourceanschlußgebiet (2) erzeugt wird, das von einem ersten Leitfähigkeitstyp dotiert ist,
- bei dem ganzflächig auf die Hauptfläche eine isolierende Schicht (3) aufgebracht wird,
- bei dem in der isolierenden Schicht (3) eine erste Öffnung (4) erzeugt wird, die auf die Oberfläche des Sourceanschlußgebietes (2) reicht und in der die Oberfläche des Sourceanschlußgebietes (2) teilweise freigelegt wird,
- bei dem in der ersten Öffnung durch epitaktisches Aufwachsen von Halbleitermaterial mit insitu-Dotierung eine vertikale Schichtenfolge (5, 6, 7) erzeugt wird, die mindestens einen Kanalbereich (6) und ein Draingebiet (7) für den MOS-Transistor umfaßt,
- bei dem innerhalb der Schichtenfolge eine zweite Öffnung (8) erzeugt wird, die mindestens so tief ist, wie es der Summe der Dicken von Draingebiet (7) und Kanalbereich (6) entspricht,
- bei dem auf die Oberfläche der zweiten Öffnung (8) ein Gatedielektrikum (9) aufgebracht wird,
- bei dem auf das Gatedielektrikum (9) eine Gateelektrode (10) aufgebracht wird.

2. Verfahren nach Anspruch 1,
- bei dem der Schichtaufbau die erste Öffnung (4) so auf füllt, daß die Oberfläche des Schichtaufbaus (7) mit der Oberfläche der isolierenden Schicht (3) im wesentlichen eben abschließt,
- bei dem die zweite Öffnung (8) mit leitfähigem Material im wesentlichen aufgefüllt wird, wobei das leitfähige Material die Gateelektrode (10) bildet.

3. Verfahren nach Anspruch 1 oder 2,
bei dem die Schichtenfolge (5, 6, 7) durch Molekularstrahlepitaxie im Temperaturbereich zwischen 400 und 700°C und im Druckbereich zwischen 0,1 mbar und 10 mbar oder durch RTP-CVD, Rapid thermal processing - chemical vapour deposition, mit SiH₂Cl₂-Gas oder SiH₄ aufgewachsen wird.

4. Verfahren nach einem der Ansprüche 1 bis 3,
- bei dem in der ersten Öffnung (4) eine erste Schicht (5) aufgewachsen wird, die vom ersten Leitfähigkeitstyp dotiert ist,
- bei dem auf die erste Schicht (5) eine zweite Schicht (6) aufgewachsen wird, die von einem zweiten, zum ersten entgegengesetzten Leitfähigkeitstyp dotiert ist und die einen Kanalbereich bildet,
- bei dem auf die zweite Schicht (6) eine dritte Schicht aufgewachsen wird, die vom ersten Leitfähigkeitstyp dotiert ist.

5. Verfahren nach Anspruch 4,
bei dem die erste Schicht (5) in einer Dicke von 50 bis 200 nm, die zweite Schicht (6) in einer Dicke von 10 bis 200 nm und die dritte Schicht in einer Dicke von 50 bis 200 nm aufgewachsen wird.

6. Verfahren nach einem der Ansprüche 1 bis 3,
- bei dem ein Inverter erzeugt wird,
- bei dem in der ersten Öffnung (24) eine erste Schicht (25) aufgewachsen wird, die vom ersten Leitfähigkeitstyp dotiert ist,
- bei dem auf die erste Schicht (25) eine zweite Schicht (26) aufgewachsen wird, die von einem zweiten, zum ersten entgegengesetzten Leitfähigkeitstyp dotiert ist und die einen Kanalbereich bildet,
- bei dem auf die zweite Schicht (26) eine dritte Schicht (27) aufgewachsen wird, die vom ersten Leitfähigkeitstyp dotiert ist,
- bei dem auf die dritte Schicht (27) eine vierte Schicht (28) aufgewachsen wird, die vom zweiten Leitfähigkeitstyp dotiert ist,
- bei dem auf die vierte Schicht (28) eine fünfte Schicht (29) aufgewachsen wird, die vom ersten Leitfähigkeitstyp dotiert ist und die einen Kanalbereich bildet,
- bei dem auf die fünfte Schicht (29) eine sechste Schicht (30) aufgewachsen wird, die vom zweiten Leitfähigkeitstyp dotiert ist,
- bei dem eine dritte Öffnung (35) erzeugt wird, die bis auf die vierte Schicht (28) reicht, deren Seitenwände mit isolierenden Spacern (36) versehen werden und die mit leitfähigem Material aufgefüllt wird,
- bei dem die sechste Schicht (30) mit einem ersten Versorgungsspannungsanschluß verbunden wird,
- bei dem das Sourceanschlußgebiet (22) mit einem zweiten Versorgungsspannungsanschluß verbunden wird,
- bei dem die Gateelektrode (33) mit einem Eingangsspannungsanschluß verbunden wird,
- bei dem die vierte Schicht (28) mit einem Ausgangsspannungsanschluß verbunden wird.

7. Verfahren nach Anspruch 6,
- bei dem die erste Schicht (25), die dritte Schicht (27), die vierte Schicht (28) und die sechste Schicht (30) jeweils in einer Dicke zwischen 50 nm und 200 nm aufgewachsen werden,
- bei dem die zweite Schicht (26) und die fünfte Schicht (29) jeweils in einer Dicke zwischen 10 nm und 200 nm aufgewachsen werden.

8. Verfahren nach einem der Ansprüche 1 bis 7,
- bei dem in Schichten der Schichtenfolge, die keinen Kanalbereich bilden, eine Dotierstoffkonzentration von mindestens 10¹⁹ cm⁻³ eingestellt wird und in Schichten, die einen Kanalbereich bilden, eine Dotierstoffkonzentration zwischen 10¹⁷ cm⁻³ und 10¹⁸ cm⁻³ eingestellt wird,
- bei dem durch thermische Oxidation bei 700 bis 800°C das Gatedielektrikum gebildet wird.

9. Verfahren nach einem der Ansprüche 1 bis 8,
- bei dem das Substrat (1) mindestens im Bereich der Hauptfläche einkristallines Silizium umfaßt, das von dem zweiten Leitfähigkeitstyp dotiert ist,
- bei dem das Sourceanschlußgebiet (2) durch Implantation oder Diffusion mit von dem ersten Leitfähigkeitstyp dotierenden Ionen in der Hauptfläche des Substrats (1) erzeugt wird.

10. Verfahren nach einem der Ansprüche 1 bis 8,
- bei dem das Substrat (1) ein SOI-Substrat mit einer Siliziumscheibe, einer darauf angeordneten isolierenden Schicht und einer darauf angeordneten einkristallinen Siliziumschicht,
- bei dem das Sourceanschlußgebiet (2) in der einkristallinen Schicht gebildet wird,
- bei dem in der einkristallinen Schicht ein das Sourceanschlußgebiet (2) umgebender, isolierender Graben erzeugt wird.

## Claims

1. Method for producing an integrated circuit arrangement having at least one MOS transistor,
- in which a source terminal region (2), which is doped with a first conductivity type, is produced at a main face of a substrate (1),
- in which an insulating layer (3) is applied surface-wide to the main face,
- in which a first opening (4), which extends as far as the surface of the source terminal region (2) and in which the surface of the source terminal region (2) is partly exposed, is produced in the insulating layer (3),
- in which a vertical layer sequence (5, 6, 7), which comprises at least one channel area (6) and one drain region (7) for the MOS transistor, is produced in the first opening by epitaxial growth of semiconductor material with in situ doping,
- in which a second opening (8), which has a depth at least corresponding to the sum of the thicknesses of the drain region (7) and channel area (6), is produced within the layer sequence,
- in which a gate dielectric (9) is applied to the surface of the second opening (8),
- in which a gate electrode (10) is applied to the gate dielectric (9).

2. Method according to Claim 1,
- in which the layer structure fills the first opening (4) in such a way that the surface of the layer structure (7) ends essentially level with the surface of the insulating layer (3),
- in which the second opening (8) is essentially filled with conductive material, the conductive material forming the gate electrode (10).

3. Method according to Claim 1 or 2, in which the layer sequence (5, 6, 7) is grown by molecular beam epitaxy in the temperature range between 400 and 700°C, and in the pressure range between 0.1 mbar and 10 mbar, or by RTP-CVD, rapid thermal processing - chemical vapour deposition, with SiH₂Cl₂ gas or SiH₄.

4. Method according to one of Claims 1 to 3,
- in which a first layer (5), which is doped with the first conductivity type, is grown in the first opening (4),
- in which a second layer (6), which is doped with a second conductivity type opposite to the first and which forms a channel area, is grown on the first layer (5),
- in which a third layer, which is doped with the first conductivity type, is grown on the second layer (6).

5. The method as claimed in Claim 4, in which the first layer (5) is grown to a thickness of from 50 to 200 nm, the second layer (6) is grown to a thickness of from 10 to 200 nm, and the third layer is grown to a thickness of from 50 to 200 nm.

6. Method according to one of Claims 1 to 3,
- in which an inverter is produced,
- in which a first layer (25), which is doped with the first conductivity type, is grown in the first opening (24),
- in which a second layer (26), which is doped with a second conductivity type opposite to the first and which forms a channel area, is grown on the first layer (25),
- in which a third layer (27), which is doped with the first conductivity type, is grown on the second layer (26),
- in which a fourth layer (28), which is doped with the second conductivity type, is grown on the third layer (27),
- in which a fifth layer (29), which is doped with the first conductivity type and which forms a channel area, is grown on the fourth layer (28),
- in which a sixth layer (30), which is doped with the second conductivity type, is grown on the fifth layer (29),
- in which a third opening (35), which extends as far as the fourth layer (28), has its side walls provided with insulating spacers (36) and is filled with conductive material, is produced,
- in which the sixth layer (30) is connected to a first supply voltage terminal,
- in which the source terminal region (22) is connected to a second supply voltage terminal,
- in which the gate electrode (33) is connected to an input voltage terminal,
- in which the fourth layer (28) is connected to an output voltage terminal.

7. Method according to Claim 6,
- in which the first layer (25), the third layer (27), the fourth layer (28) and the sixth layer (30) are each grown to a thickness of between 50 nm and 200 nm,
- in which the second layer (26) and the fifth layer (29) are each grown to a thickness of between 10 nm and 200 nm.

8. Method according to one of Claims 1 to 7,
- in which a dopant concentration of at least 10¹⁹ cm⁻³ is set in layers of the layer sequence which do not form a channel area, and a dopant concentration of between 10¹⁷ cm⁻³ and 10¹⁸ cm⁻³ is set in layers which do form a channel area,
- in which the gate dielectric is formed by thermal oxidation at from 700 to 800°C.

9. Method according to one of Claims 1 to 8,
- in which the substrate (1), at least in the area of the main surface, comprises monocrystalline silicon, which is doped with the second conductivity type,
- in which the source terminal region (2) is produced, through implantation or diffusion with ions doped with the first conductivity type, in the main surface of the substrate (1).

10. Method according to one of Claims 1 to 8,
- in which the substrate (1) is an SOI substrate having a silicon wafer, an insulating layer arranged thereon and a monocrystalline silicon layer arranged thereon,
- in which the source terminal region (2) is formed in the monocrystalline layer,
- in which an insulating trench, surrounding the source terminal region (2), is produced in the monocrystalline layer.

## Revendications

1. Procédé de fabrication d'un montage de circuit intégré comportant au moins un transistor MOS,
- dans lequel on produit sur une surface principale d'un substrat (1) une zone (2) de bornes de source qui est dopée en un premier type de conductivité,
- dans lequel on dépose sur la surface principale, sur toute la surface, une couche (3) isolante,
- dans lequel on ménage dans la couche (3) isolante une première ouverture (4) qui va à la surface de la zone (2) de bornes de source et dans laquelle la surface de la zone (2) de bornes de source est partiellement dégagée,
- dans lequel on produit dans la première ouverture. par croissance épitaxiale de matériau semi-conducteur avec dopage in situ, une succession (5, 6, 7) de couches verticales qui comprend au moins une zone (6) de canal et une zone (7) de drain pour le transistor MOS,
- dans lequel on ménage à l'intérieur de la succession de couches une deuxième ouverture (8) qui est au moins aussi profonde que ce qui correspond à la somme des épaisseurs de la zone (7) de drain et de la zone (6) de canal,
- dans lequel on dépose à la surface de la deuxième ouverture (8) un diélectrique (9) de grilles,
- dans lequel on dépose sur le diélectrique (9) de grilles une électrode (10) de grilles.

2. Procédé suivant la revendication 1,
- dans lequel la structure de couches remplit la première ouverture (4) de telle manière que la surface de la structure (7) de couches se termine de manière sensiblement plane par la surface de la couche (3) isolante,
- dans lequel on remplit sensiblement la deuxième ouverture (8) de matériau conducteur, le matériau conducteur formant l'électrode (10) de grilles.

3. Procédé suivant la revendication 1 ou 2,
- dans lequel on fait croître la succession (5, 6, 7) de couches par épitaxie par faisceaux moléculaires dans l'intervalle de température compris entre 400 et 700°C et dans l'intervalle de pression compris entre 0,1 mbar et 10 mbar ou par RTP-CDV-Rapid thermal processing - Chemical vapour deposition (traitement thermique rapide - dépôt chimique en phase vapeur) avec du gaz SiH₂Cl₂ ou SiH₄.

4. Procédé suivant l'une des revendications 1 à 3,
- dans lequel on fait croître dans la première ouverture (4) une première couche (5) qui est dopée d'un dopage du premier type de conductivité,
- dans lequel on fait croître sur la première couche (5) une deuxième couche (6) qui est dopée d'un dopage d'un deuxième type de conductivité opposé au premier et qui forme une zone de canal,
- dans lequel on fait croître sur la deuxième couche (6) une troisième couche qui est dopée d'un dopage du premier type de conductivité.

5. Procédé suivant la revendication 4,
dans lequel on fait croître la première couche (5) en une épaisseur de 50 à 200 nm, la deuxième couche (6) en une épaisseur de 10 à 200 nm et la troisième couche en une épaisseur de 50 à 200 nm.

6. Procédé suivant l'une des revendications 1 à 3,
- dans lequel on produit un inverseur,
- dans lequel on fait croître dans la première ouverture (24) une première couche (25) qui est dopée d'un dopage du premier type de conductivité,
- dans lequel on fait croître sur la première couche (25) une deuxième couche (26) qui est dopée d'un dopage d'un deuxième type de conductivité opposé au premier et qui forme une zone de canal,
- dans lequel on fait croître sur la deuxième couche (26) une troisième couche (27) qui est dopée d'un dopage du premier type de conductivité,
- dans lequel on fait croître sur la troisième couche (27) une quatrième couche (28) qui est dopée d'un dopage du deuxième type de conductivité,
- dans lequel on fait croître sur la quatrième couche (28) une cinquième couche (29) qui est dopée d'un dopage du premier type de conductivité et qui forme une zone de canal,
- dans lequel on fait croître sur la cinquième couche (29) une sixième couche (30) qui est dopée d'un dopage du deuxième type de conductivité,
- dans lequel on ménage une troisième ouverture (35) qui va jusqu'à la quatrième couche (28), dont les parois latérales sont munies de couches (36) d'espacement isolantes et qui est remplie d'un matériau conducteur,
- dans lequel on relie la sixième couche (30) à une première borne de tension d'alimentation,
- dans lequel on relie la zone (22) de bornes de source à une deuxième borne de tension d'alimentation,
- dans lequel on relie l'électrode (33) de grilles à une borne de tension d'entrée,
- dans lequel on relie la quatrième couche (28) à une borne de tension de sortie.

7. Procédé suivant la revendication 6,
- dans lequel on fait croître la première couche (25), la troisième couche (27), la quatrième couche (28) et la sixième couche (30) chacune en une épaisseur comprise entre 50 nm et 200 nm,
- dans lequel on fait croître la deuxième couche (26) et la cinquième couche (29), chacune en une épaisseur comprise entre 10 nm et 200 nm.

8. Procédé suivant l'une des revendications 1 à 7,
- dans lequel on règle dans des couches de la succession de couches qui ne forment pas une zone de canal une concentration en substance dopante d'au moins 10¹⁹ cm⁻³ et on règle dans des couches qui forment une zone de canal une concentration en substance dopante comprise entre 10¹⁷ cm⁻³ et 10¹⁸ cm⁻³,
- dans lequel on forme le diélectrique de grilles par oxydation thermique à 700 à 800°C.

9. Procédé suivant l'une des revendications 1 à 8,
- dans lequel le substrat (1) comporte, au moins dans la zone de la surface principale, du silicium monocristallin qui est dopé d'un dopage du deuxième type de conductivité,
- dans lequel on produit dans la surface principale du substrat (1) la zone (2) de bornes de source par implantation ou diffusion par des ions dopants à dopage du premier type de conductivité.

10. Procédé suivant l'une des revendications 1 à 8,
- dans lequel le substrat (1) est un substrat SOI comportant un disque de silicium, une couche isolante disposée sur ce disque et une couche de silicium monocristalline disposée sur cette couche isolante,
- dans lequel la zone (2) de bornes de source est formée dans la couche monocristalline,
- dans lequel on produit dans la couche monocristalline un sillon isolant, entourant la zone (2) de bornes de source.
